# EUROPÄISCHE PATENTSCHRIFT

(11) **EP 1 533 875 B1**
(45) Veröffentlichungstag und Bekanntmachung des Hinweises auf die Patenterteilung: **14.11.2007**
(21) Anmeldenummer: 04027587.7
(22) Anmeldetag: 19.11.2004
(51) Int. Cl.: H01S 5/14, H01S 5/06

(54) **Laserdioden-Anordnung mit externem Resonator**
Laserdiode assembly with external resonator
Ensemble diode laser comprenant un résonateur externe

(30) Priorität: 19.11.2003 DE 20317902 U
(43) Veröffentlichungstag der Anmeldung: 25.05.2005
(73) Patentinhaber: Sacher, Joachim, 35041 Marburg/Lahn (DE)
(72) Erfinder: Sacher, Joachim, 35041 Marburg/Lahn (DE)
(74) Vertreter: Buchhold, Jürgen

(56) Entgegenhaltungen:
- EP-A- 0 347 213
- EP-A- 0 647 995
- FR-A- 2 595 013
- US-A- 5 325 378
- US-A- 5 596 596
- "Broad wavelength tunability of grating-coupled external cavity midinfrared semiconductor lasers" APPLIED PHYSICS LETTERS, AMERICAN INSTITUTE OF PHYSICS. NEW YORK, US, Bd. 69, Nr. 19, 4. November 1996 (1996-11-04), Seite 2804, XP012016462 ISSN: 0003-6951
- FAVRE F ET AL: "82 NM OF CONTINUOUS TUNABILITY FOR AN EXTERNAL CAVITY SEMICONDUCTOR LASER" ELECTRONICS LETTERS, IEE STEVENAGE, GB, Bd. 27, Nr. 2, 17. Januar 1991 (1991-01-17), Seiten 183-184, XP000201222 ISSN: 0013-5194
- CHANN B ET AL: "FREQUENCY-NARROWED EXTERNAL-CAVITY DIODE-LASER-ARRAY BAR" OPTICS LETTERS, OPTICAL SOCIETY OF AMERICA, WASHINGTON, US, Bd. 25, Nr. 18, 15. September 2000 (2000-09-15), Seiten 1352-1354, XP000975112 ISSN: 0146-9592

## Beschreibung

Die Erfindung betrifft eine Laserdioden-Anordnung mit einem externen Resonator gemäß dem Oberbegriff von Anspruch 1.

Durch eine in Flußrichtung betriebene Halbleiter-Laserdiode kann man mittels stimulierter Emission kohärentes Laserlicht erzeugen. Dieses hat jedoch ohne weitere Stabilisierungsmaßnahmen eine relativ große Linienbreite. Außerdem läßt sich die Laserfrequenz bzw. -wellenlänge allein über die Laserdiodentemperatur oder den Injektionsstrom nur unzuverlässig einstellen.

Um diese Nachteile zu beheben, kombiniert man die Laserdiode gewöhnlich mit einem externen Resonator, der über wellenlängenselektive Elemente wie Gitter und Filter nur Licht bestimmter Wellenlängen - den Resonatormoden - in die Laserdiode zurückkoppelt. Dies führt zu einer Verstärkung der stimulierten Emission auf der jeweils ausgewählten Wellenlänge. Gleichzeitig läßt sich über das wellenlängenselektive Element die Emissionswellenlänge über den Verstärkungsbereich der Laserdiode durchstimmen.

Zwei typische Laser-Anordnungen mit externen Resonatoren, die wellenlängenselektive Elemente enthalten, sind die Littrow- und die Littman-Anordnung.

Bei der Littrow-Anordnung erfolgt die Rückkopplung über ein optisches Beugungsgitter, das so orientiert ist, daß die erste Beugungsordnung in die Laserdiode zurückreflektiert wird. Die direkte Reflexion (0. Beugungsordnung) bildet den Auskopplungsstrahl des Lasers. Dreht man das Gitter, wird das System verstimmt und es wird eine andere longitudinale Resonatormode verstärkt.

Beim Littman-Metcalf-Aufbau fällt das Licht unter einem flachen Winkel auf das optische Beugungsgitter, wobei die Beugung erster Ordnung auf einen Resonatorendspiegel gelenkt wird. Dieser reflektiert das Licht über das Gitter zurück in die Laserdiode, während die Beugung 0. Ordnung als Nutzstrahl über das Gitter ausgekoppelt wird. Die Verstimmung der Laserfrequenz erfolgt über eine Drehung des Spiegels. Wenn hierbei Rotation und Translation im richtigen Verhältnis gekoppelt sind, ist es möglich, den Laser über mehrere THz kontinuierlich modensprungfrei zu verstimmen.

Die Verwendung eines externen Resonators bringt gewöhnlich einen Verlust bei der Laserleistung mit sich, gleichzeitig wird aber die Resonatorlänge von der Temperatur weitgehend unabhängig. Um eine möglichst gute Ankopplung des externen Resonators an die Halbleiter-Laserdiode zu erreichen, wird die dem Resonator zugewandte Laserfacette der Laserdiode entspiegelt, so daß deren Reflektivität z.B. kleiner 0.1 % ist. Die dem externen Resonator abgewandte Rückfacette der Laserdiode ist hingegen verspiegelt, wobei die Reflektivität möglichst nahe 1 liegt. Das optische Beugungsgitter des externen Resonators hat meist eine Reflektivität von etwa 5 %, um sowohl eine ausreichende Rückkopplung als auch eine akzeptable Ausgangsleistung zu erzielen.

Für eine Steigerung der Ausgangsleistung wäre es notwendig, die Anregungsleistung (den Injektionsstrom) der Laserdiode zu erhöhen. Dies ist jedoch nur begrenzt möglich. Fließt dauerhaft zuviel Strom durch den Halbleiterkristall, kann die Laserdiode zerstört werden. Die Erzeugung kurzer Laserpulse würde dies zwar vermeiden. Die durch Pulsbetrieb oder Gütemodulation erzeugte Ausgangsleistung würde jedoch nur für eine kurze Zeitdauer zur Verfügung, was in zahlreichen Anwendungen nicht ausreichend ist. Eine alternative Möglichkeit zur Erhöhung der Ausgangsleistung bei einer kontinuierlich betriebenen Laserdioden-Anordnung mit externem Resonator bestünde darin, die Reflektivität des Beugungsgitters zu senken, was jedoch ebenfalls nur bedingt möglich ist. Eine zu geringe Reflektivität wirkt sich ungünstig auf die Systemeigenschaften aus. Der Laser wird instabil.

Le et al offenbaren in "Broad wavelength tunability of grating-coupled external cavity midinfrared semiconductor lasers", Appl. Phys. Lett., 69 (1996) 19, pp. 2804 bis 2806 eine Laserdioden-Anordnung in Littrow-Anordnung mit einer Laserdiode, die mit ihrer Rückfacette und ihrer Frontfacette einen Resonator bildet, und mit einem daran angekoppelten externen Resonator, der eine optische Transmissionskomponente und ein wellenlängenselektives optisches Reflexionselement aufweist. Der externe Resonator koppelt das von der Laserdiode emittierte Laserlicht über deren Frontfacette in den ersten Resonator zurück. Die erzeugte Laserstrahlung wird über die Rückfacette der Laserdiode ausgekoppelt.

Die Reflektivität der verwendeten Laserdiode wird durch den Brechnungsindexsprung zwischen Lasermaterial und der Umgebung bestimmt. Aufgrund des Brechnungsindex des von Le et al verwendeten Lasermaterials stellt sich eine natürliche Reflektivität der Rückfacette und der Frontfacette von 0.06 = 6 % ein, während die Reflektivität des optischen Reflexionselements mit 0,5 = 50 % angegeben wird.

Ziel der Erfindung ist es, diese und weitere Nachteile des Standes der Technik zu überwinden und eine Laserdioden-Anordnung mit einem externen Resonator zu schaffen, das eine deutlich höhere Leistungsausbeute ermöglicht. Angestrebt wird ferner die Erzeugung von einmodigem Laserlicht, dessen Wellenlänge kontinuierlich und frei von Modensprüngen durchstimmbar ist. Der Aufbau soll mit einfachen Mitteln kostengünstig realisierbar und leicht zu handhaben sein. Die Abbildungseigenschaften des externen Resonators sollen justageinvariant sein.

Hauptmerkmale der Erfindung sind im kennzeichnenden Teil von Anspruch 1 angegeben. Ausgestaltungen sind Gegenstand der Ansprüche 2 bis 20.

Bei einer Laserdioden-Anordnung zur Erzeugung von einmodiger, durchstimmbarer Laserstrahlung, mit einer Laserdiode, die eine Rückfacette und eine Frontfacette aufweist und einen ersten Resonator bildet, und mit einem daran angekoppelten externen Resonator, der wenigstens eine optische Transmissionskomponente und wenigstens ein wellenlängenselektives optisches Reflexionselement aufweist und von der Laserdiode emittiertes Laserlicht über die Frontfacette in den ersten Resonator zurückkoppelt, wobei das optische Reflexionselement ein Beugungsgitter umfasst und wobei die Laserstrahlung über die Rückfacette der Laserdiode auskoppelbar ist, sieht die Erfindung laut Anspruch1 vor, daß das Verhältnis der Reflektivität der Rückfacette zur Reflektivität des optischen Reflexionselements sehr viel kleiner als 1, vorzugsweise kleiner als 0,1 ist, wobei in beiden Fällen die Reflektivität der Rückfacette kleiner oder gleich 0,01 und die Reflektivität des optischen Reflexionselements größer oder gleich 0,95 ist.

Dadurch ist es möglich, aus der Laserdioden-Anordnung eine sehr viel höhere Leistung auszukoppeln, wobei zugleich Schwankungen der Lichtleistung und Modensprünge in der spektralen Durchstimmkurve des Lasersystems wirksam vermieden werden. Dazu trägt insbesondere bei, wenn das Verhältnis der Reflektivität der Rückfacette zur Reflektivität des optischen Reflexionselements kleiner als 0,1 ist und wenn die Reflektivität der Rückfacette bevorzugt kleiner oder gleich 1 % und die Reflektivität des optischen Reflexionselements größer oder gleich 95 % ist. Diese Werte lassen sich einfach und kostengünstig realisieren.

Die Erfindung sieht in Anspruch 1 weiter vor, und daß der Transmissionskomponente eine zerstreuende Zylinderlinse zugeordnet ist, deren parallel zu ihrer Zylindermantelfläche verlaufende Achse im wesentlichen parallel zu dem optischen Reflexionselement angeordnet ist, wobei die Achse der Zylinderlinse parallel zu den Gitterlinien des Beugungsgitters verläuft.

Justiert man die Transmissionskomponente derart, daß auf dem bzw. den optischen Reflexionselementen eine punktgenaue Abbildung der Laserfacette erfolgt, so entsteht durch die zerstreuende Zylinderlinse ein Linienfokus. Dadurch wird die Laser-Anordnung justageinvariant gegenüber Verkippungen des bzw. der Reflexionselemente um eine Achse parallel zur Längsachse A der Laserdiode.

Es sind bereits Resonatoren bekannt, die justageinvariant ausgebildet sind. EP-A2-0 347 213 schlägt beispielsweise ein Laserdiodensystem mit externem Resonator in Littrow-Anordnung vor, das neben einer Kollimationsoptik und einem Beugungsgitter einen anamorphotischen Übertragungsbereich aufweist, der den Laserstrahl derart formt, daß er auf dem Beugungsgitter einen Linienfokus bildet. Hierzu ist hinter der Kollimationslinse eine zylindrische Sammellinse angeordnet, deren optische Achse senkrecht zu den Gitterlinien des Resonatorgitters liegt. Zusätzliche Prismen dienen als Strahlaufweiter, um die Breite des Laserstrahls weiter zu erhöhen.

Eine solche Vorrichtung leidet jedoch unter der Vielzahl der optischen Bauelemente und der hieraus resultierenden Baugröße. Eine Miniaturisierung dieser Vorrichtung erscheint aufgrund der Qualitätsprobleme bei der Herstellung kurzbrennweitiger Zylindeninsen nur schwer möglich.

Die erfindungsgemäße Optik hingegen überwindet derartige Nachteile. Sie läßt sich äußerst kompakt und robust ausbilden, wodurch die gesamte Laseranordnung selbst mechanischen Stößen und Vibrationen problemlos standhält. Selbst der Einsatz in meist rauhen industriellen Umgebungen oder im Weltraum ist möglich. Das von dem wellenlängenselektiven Element rückgekoppelte Licht wird stets exakt auf die lichtemittierende Laserfacette fokussiert, so daß auch auf Dauer weder Modensprünge noch Leistungsverluste auftreten. Aufwendige Ausgleichsmechaniken sind nicht erforderlich.

Anspruch 2 sieht vor, daß die Laserdiode in Axialrichtung eine Länge aufweist, die größer oder gleich 500 µm ist, was ebenfalls zu einer deutlichen Steigerung der auskoppelbaren Leistung beiträgt. Gleichzeitig verringert sich die Linienbreite der emittierten Laserstrahlung.

In der Ausbildung von Anspruch 3 ist im Bereich der Rückfacette eine optische Transmissionskomponente angeordnet, z.B. eine Kollimationslinse. Diese sorgt dafür, daß das divergent aus der Rückfacette der Laserdiode austretende Laserlicht parallelisiert wird. Man kann aber auch - je nach Verwendung des Laserlichts - eine andere Optik verwenden und/oder dem Kollimator nachschalten.

In vorteilhafter Weiterbildung ist laut Anspruch 4 eine Einrichtung zur Variation der Ankopplungsgüte des ersten Resonators an den externen Resonator vorgesehen. Dadurch ist es möglich, die optische Länge des von der Laserdiode gebildeten ersten Resonators gezielt zu verändern, so daß beide Resonatoren über nahezu den gesamten Wellenlängenbereich stets optimal miteinander gekoppelt sind. Sobald beim Durchstimmen des Lasers in der Ausgangsstrahlung Leistungsschwankungen auftreten oder zu erkennen sind, besteht die Möglichkeit dies durch eine Veränderung der Ankopplungsgüte unmittelbar auszugleichen. Mithin ist es auf einfache Art möglich, einmodige, modensprungfrei durchstimmbare Laserstrahlung zu erzeugen. Aufwendige mechanische Justiermittel am oder im externen Resonator sind nicht erforderlich, was sowohl den Aufbau als auch die Handhabung wesentlich vereinfacht.

Gemäß Anspruch 5 ist die Einrichtung zur Variation der Ankopplungsgüte an oder in dem ersten Resonator ausgebildet, was einen kompakten Aufbau ermöglicht. Dazu trägt auch Anspruch 6 bei, wenn nämlich die Einrichtung zur Variation der Ankopplungsgüte an oder in der Laserdiode ausgebildet ist. Hierzu sieht Anspruch 7 beispielsweise vor, daß die Einrichtung zur Variation der Ankopplungsgüte einen auf der Laserdiode aufgebrachten elektrischen Anschlußkontakt umfaßt, der in voneinander unabhängig ansteuerbare Anschlußsegmente unterteilt ist.

Konstruktiv ist es dabei günstig, wenn der Anschlußkontakt nach Anspruch 8 senkrecht zur Längsachse der Laserdiode unterteilt ist, wobei das der Rückfacette zugewandte erste Anschlusssegment eine Länge aufweist, die größer ist als die Länge des weiteren Anschlußsegments. Über letzteres kann man rasch und präzise die Güte des ersten Resonators verändern, ohne die Hauptfunktion der Laserdiode zu beeinträchtigen.

In der Ausbildung von Anspruch 9 ist jedes Anschlusssegment über eine Regelschaltung mit einem Steuerstrom beaufschlagbar. Dabei ist der dem ersten Anschlußsegment zugeführte Steuerstrom konstant, während sich der dem weiteren Anschlußsegment zugeführte Steuerstrom in Abhängigkeit von der Position der wellenlängenselektiven optischen Reflexionselemente relativ zur Laserdiode über die Regelschaltung verändern lässt, wodurch das von dem externen Resonator zurückgekoppelte Laserlicht von der Laserdiode im Bereich des zweiten Segments mehr oder weniger verstärkt wird, bevor es in den Hauptbereich der Laserdiode gelangt, der von dem ersten Anschlußsegment definiert wird. Mit der Stromänderung ändert sich die Temperatur in der aktiven Zone der Laserdiode, die dadurch ihre optische Länge ändert. Mithin ist es durch einfache Stromänderung an den Anschlußsegmenten möglich, die Güte des von der Laserdiode gebildeten ersten Resonators gezielt zu verändern, so daß das Zwei-Resonator-System stets optimal aneinander gekoppelt ist.

Die Variation der Güte des ersten Resonators kann auch passiv erfolgen, indem der dem weiteren Anschlußsegment zugeführte Steuerstrom und die Position der bzw. des wellenlängenselektiven optischen Reflexionselements in einer über die Regelschaltung vorgebbaren Beziehung zueinander stehen. Wenn also das Reflexionselement, z.B. ein Gitter, eine bestimmte Winkelstellung einnimmt, wird an dem weiteren Ansteuersegment von der Regelschaltung ein entsprechend zugeordneter Strom angelegt. Verändert man die Winkelstellung des Gitters, z.B. beim Durchstimmen des Lasers, wird der Steuerstrom von der Regelschaltung automatisch nachgeführt, so daß eine stets modensprungfreie und leistungskonstante Laserstrahlung ausgekoppelt wird.

Ergänzend oder alternativ kann man den Steuerstrom an dem weiteren Anschlußsegment in Abhängigkeit von der Leistung der aus der Laserdioden-Anordnung ausgekoppelten Laserstrahlung verändern. Sobald sich beim Durchstimmen des Lasers die Ausgangsleistung in Bezug auf einen definierten Schwellenwert ändert, greift die Regelschaltung ein und verändert den Steuerstrom an dem weiteren Anschlußelement.

Für eine optimale Auskopplung der Laserstrahlung über das wellenlängenselektive Element ist es günstig, wenn die Rückfacette der Laserdiode nach Anspruch 10 verspiegelt und die dem externen Resonator zugewandte Frontfacette der Laserdiode gemäß Anspruch 11 mit einer Antireflexionsbeschichtung versehen ist, wobei die Reflektivität der Rückfacette in Einklang mit Anspruch 12 bevorzugt kleiner als 0,1 % ist.

Anspruch 13 sieht überdies vor, daß die optische Transmissionskomponente ein Kollimator ist. Dieser sorgt dafür, daß das aus der Laserdiode austretende divergente Laserlicht als Parallelstrahlbündel auf das wellenlängenselektive Reflexionselement fällt. Letzteres ist laut Anspruch 14 bevorzugt ein optisches Beugungsgitter und/oder gemäß Anspruch 15 ein Spiegel. Dementsprechend bilden die Laserdiode und der externe Resonator nach Anspruch 16 eine Littman- oder eine Littrow-Anordnung.

In der Weiterbildung von Anspruch 17 ist die Laserdiode ein Quantenkaskadenlaser, ein Quantenpunktlaser oder ein Dilute-Nitrid-Arsenid-Laser, was die Nutzung größerer oder anders gelagerter Wellenlängenbereiche eröffnet.

Verschiedene Varianten gehen aus den Ansprüchen 18 und 19 hervor, wonach die Zylinderlinse zwischen der Laserdiode und der Sammellinse angeordnet ist. Oder man setzt die Sammellinse zwischen die Laserdiode und die Zylinderlinse.

Eine weitere Ausführungsform der Erfindung sieht vor, daß das optische Reflexionselement von zwei Teilgittern gebildet wird, die in einem Winkel von 90° zueinander angeordnet sind. Auch hierdurch wird die Laser-Anordnung justageinvariant gegenüber Verkippungen der ein Hutgitter bildenden Teilgitter senkrecht zu den Gitterlinien.

Weitere Merkmale, Einzelheiten und Vorteile der Erfindung ergeben sich aus dem Wortlaut der Ansprüche sowie aus der folgenden Beschreibung von Beispielen und Ausführungsformen anhand der Zeichnungen. Es zeigen:
- Fig. 1: eine schematische Darstellung einer Laserdioden-Anordnung in Littman-Anordnung (Beispiel um das Verständnis der Erfindung zu erleichtern),
- Fig. 2: eine schematische Darstellung einer Laserdioden-Anordnung in Littrow-Anordnung,

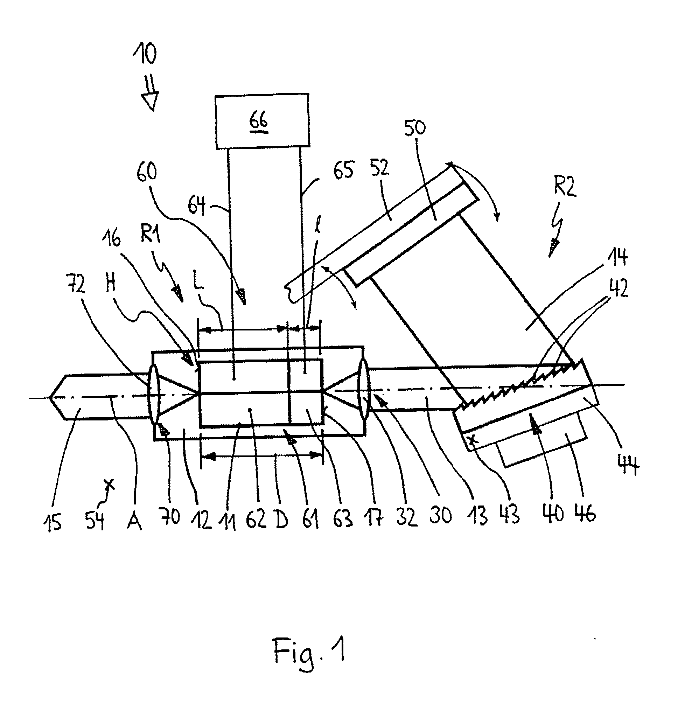

Die in Fig. 1 allgemein mit 10 bezeichnete Laserdioden-Anordnung zur Erzeugung von einmodiger, durchstimmbarer Laserstrahlung 15 ist als Littman-Anordnung ausgebildet. Sie umfaßt eine Halbleiter-Laserdiode 11, die auf einem Träger 12, z.B. einer Grundplatte oder einem Montageblock, befestigt ist. Die Rückfacette 16, deren Reflektivität kleiner als 0,1 % beträgt, und die Frontfacette 17 der Laserdiode 11 bilden die Endflächen eines ersten Resonators R1, dessen Länge von der Länge D des Halbleiterkristalls der Laserdiode 11 bestimmt wird.

Das von der Laserfacette 17 emittierte Laserlicht 13 wird von einer optischen Transmissionskomponente 30 in Form einer rotationssymmetrischen Kollimationslinse 32 auf die Oberfläche eines optischen Beugungsgitters 40 fokussiert, das als wellenlängenselektives Reflexionselement zusammen mit einem Spiegel 50 Bestandteil eines externen Resonators R2 ist. Die Reflektivität des planen Gitters 40 beträgt vorzugsweise etwa 95 %, so daß ein Großteil des Laserlichts 14 der ersten Beugungsordnung von dem Gitter 40 auf den Spiegel 50 gelenkt wird. Von dort wird das Licht zurückreflektiert und - nachdem es von dem Gitter 40 ein zweites Mal gebeugt wurde - in die Laserdiode 11 zurückgekoppelt.

Die Auskopplung der Laserstrahlung 15 erfolgt über die Rückfacette 16 der Laserdiode 11, die hierzu mit einer Reflektivität von kleiner oder gleich 1 % versehen ist, d.h. das Verhältnis der Reflektivität der Rückfacette 16 zur Reflektivität des optischen Gitters 40 ist sehr viel kleiner als 1, vorzugsweise sehr viel kleiner als 0,1. Dadurch kann man der Laserdioden-Anordnung 10 deutlich mehr Leistung entnehmen, weil von dem externen Resonator R2 sehr viel mehr Licht in die Laserdiode 11 zurückgekoppelt wird. Eine weitere Leistungssteigerung erzielt man, wenn die Laserdiode 11 in Axialrichtung A eine Länge D aufweist, die größer oder gleich 500 µm ist.

Für eine gezielte Nutzung des von der Laserdioden-Anordnung 10 emittierten Laserstrahlung 15 ist im Bereich der Rückfacette 16 eine optische Transmissionskomponente 70 angeordnet, z.B. eine Kollimationslinse 72.

Das Gitter 40 ist bevorzugt auf einem Träger 44 montiert, der mittels Justier- bzw. Stellmitteln 46, z.B. einem Verschiebetisch, um wenigstens eine Achse 43 parallel zu den Gitterlinien 42 verschwenkt und/oder in verschiedenen Raumrichtungen linear verschoben werden kann. Die Gitterlinien 42 des Gitters 40 verlaufen senkrecht zur Längsachse A der Laserdiode 11.

Der Spiegel 50 ist auf einem Tragarm 52 befestigt, der um eine Achse 54 schwenkbar gelagert ist. Letztere verläuft parallel zur Spiegelebene. Wird der Tragarm 52 um die Achse 54 verschwenkt, ändert sich die von dem Gitter 40 in die Laserdiode 11 zurückgekoppelte Wellenlänge. Der Laser 10 wird verstimmt. Gleichzeitig ändert sich die durch die Länge des externen Resonators R2 bestimmte Wellenlänge, was jedoch durch eine entsprechende Verschiebung des Gitters 40 relativ zum Spiegel 50 bzw. relativ zu dessen Drehachse 54 unter Einbeziehung mehrerer Dispersionsordnungen ausgeglichen werden kann.

Beim Durchstimmen der Wellenlänge über den Spiegel 50 zeigt sich trotz Nachführung des Gitters 40 die nicht verschwindende Reflektivität der dem externen Resonator R2 zugewandten Frontfacette 17 der Laserdiode 11 in Form von Leistungsschwankungen sowie in Form von Veränderungen der Resonatorgüte, was gewöhnlich zu Modensprüngen führt.

Um dem zu begegnen, ist der von der Laserdiode 11 gebildete erste Resonator R1 mit einer Einrichtung 60 versehen, mit der man die Ankopplungsgüte des ersten Resonators R1 an den externen Resonator R2 gezielt variieren kann. Die Einrichtung 60 umfaßt im wesentlichen einen auf der Laserdiode 11 aufgebrachten elektrischen Anschlußkontakt 61, der senkrecht zur Längsachse A in zwei separate Anschlußsegmente 62, 63 unterteilt ist, sowie eine Regelschaltung 66. Jedes Anschlußsegment 62, 63 ist über eine Anschlußleitung 64, 65 an die Regelschaltung 66 angeschlossen. Mit dieser kann man die Anschlußsegmente 62, 63 unabhängig voneinander mit einem Steuer- bzw. Segmentstrom beaufschlagen. Man erkennt in Fig. 1, daß das der Rückfacette 16 zugewandte erste Anschlußsegment 62 eine Länge L aufweist, die größer ist als die Länge I des weiteren Anschlußsegments 63 und daß die Gesamtlänge L + I der Anschlußsegmente 62, 63 bis auf eine schmale (nicht dargestellte) Lücke der Länge D der Laserdiode 11 entspricht. Letztere wird mithin durch die Anschlußsegmente 62, 63 in ein größeres Hauptsegment H und ein vorgelagertes kleineres Steuersegment S unterteilt.

Hält man beispielsweise den Segmentstrom an dem ersten Anschlußsegment 62 konstant, so kann man durch eine Änderung des dem zweiten Anschlußsegment 63 zugeführten Segmentstroms das von dem externen Resonator R2 zurückgekoppelte Laserlicht in dem Steuersegment S mehr oder weniger verstärken, bevor es in das Hauptsegment H der Laserdiode 11 gelangt. Die Stromänderung am zweiten Anschlußsegment 63 führt zu einer Temperaturänderung im Steuersegment S und damit zu einer Temperaturänderung in der aktiven Zone der Laserdiode 11. Dadurch ändert sich die optische Länge der Laserdiode 11 bzw. des Resonators R1, der mithin stets optimal an den externen Resonator R2 angekoppelt ist.

Durch die separat steuerbaren Ströme an den Anschlußsegmenten 62, 63 wird zudem eine gezielte Variation des Aufnahmevermögens des ersten Resonators R1 für das von dem externen Resonator R2 zurückgekoppelte Laserlicht erreicht, was zu einer deutlichen Steigerung der Laserlichtausbeute führt. Beispielsweise kann man bei einer sich verschlechternden Ankopplung die Stromzuführung am zweiten Anschlußsegment 63 erhöhen. Verbessert sich die Ankopplung wird der Segmentstrom beim weiteren Durchstimmen der Wellenlänge wieder verringert.

Die Regelung der Segmentströme an den Anschlußsegmenten 62, 63 übernimmt die Regelschaltung 66, die hierzu mit einer (nicht dargestellten) elektronischen Steuerung versehen ist. Bei einer passiven Anpassung der Ankopplungsgüte wird der dem zweiten Anschlußsegment 63 zugeführte Steuerstrom in Abhängigkeit von der Position des Gitters 40 und/oder des Spiegels 50 relativ zur Laserdiode 11 bzw. zum Resonator R1 verändert, wobei die Stromstärke und die Position des Gitters 40 bzw. des Spiegels 50 in einer über die Regelschaltung 66 vorgebbaren Beziehung zueinander stehen. Dadurch ist sichergestellt, daß beim Durchstimmen des Lasers 10 die Ankopplungsgüte stets korrekt nachgeführt wird.

Um die Anpassung der Ankopplungsgüte zu automatisieren, wird während dem Durchstimmen der Wellenlänge die Leistung der ausgekoppelten Laserstrahlung 15 gemessen und der dem zweiten Anschlußsegment 63 zugeführte Strom in Abhängigkeit von der erfaßten Leistung und je nach Winkelstellung des Gitters 40 und/oder des Spiegels 50 nachgeführt. Die Laserdioden-Anordnung 10 emittiert damit stets eine einmodige Laserstrahlung 15, die frei von Modensprüngen durchstimmbar ist. Aufwendige mathematische Berechnungen zur Festlegung der Drehachse 54 für den Spiegel oder eine Aufwendige Nachführung des Gitters 40 ist nicht mehr erforderlich. Die gesamte Anordnung 10 läßt sich äußerst kompakt und kostengünstig realisieren und ebenso einfach handhaben.

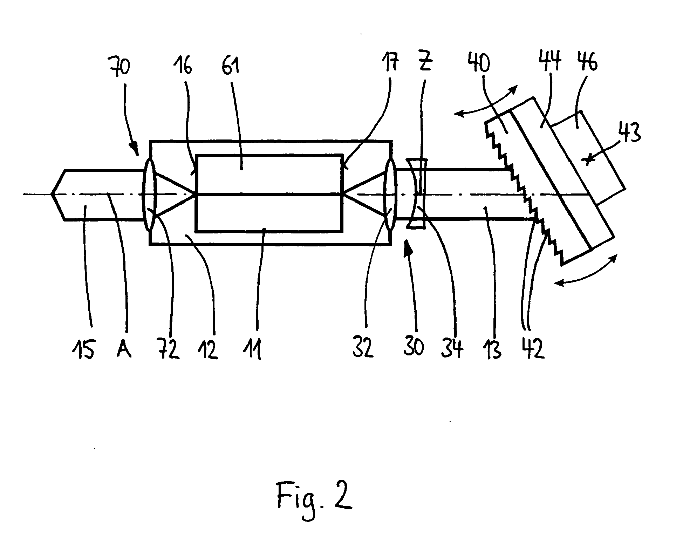

In der Ausführungsform von Fig. 2 bildet die Laserdioden-Anordnung 10 eine Littrow-Anordnung. Diese besteht im wesentlichen aus der Laserdiode 11 und dem externen Resonator R2, der von der optischen Transmissionskomponente 30 in Form einer Sammellinse 32 und dem wellenlängenselektiven optischen Reflexionselement 40 in Form eines planen Beugungsgitters als Resonatorendspiegel gebildet wird. Die Auskopplung des Laserlichts 15 erfolgt auch hier über die Rückfacette 16 der Laserdiode 11.

Hinter der Sammellinse 32 ist im Strahlengang des emittierten Laserlichts 13 eine zerstreuende Zylinderlinse 34 angeordnet, deren Achse Z parallel zu den Gitterlinien 42 des Gitters 40 verläuft. Position und Fokus der Zylinderlinse 34 sind so gewählt, daß auf dem Gitter 40 ein Linienfokus entsteht, d.h. das von der Laserfacette 17 emittierte Laserlicht 13 wird von der Transmissionskomponente 30 als (nicht gezeigte) schmale Linie auf dem Gitter 40 abgebildet, wobei die Höhe der Linie sehr viel kleiner ist als deren Breite. Letztere bestimmt die Selektivität des Gitters 40.

Durch diese Anordnung und Fokussierung wird der Laser 10 insgesamt justageinvariant gegenüber Verkippungen des Gitters 40 um eine Achse senkrecht zu den Gitterlinien 42, die beispielsweise beim Verschwenken des Gitters 40 um die Achse 43 oder durch Erschütterungen entstehen können. Überdies treten keine durch die Resonatoroptik 30, 40, 50 bedingten Leistungsverluste auf, weil die Abbildungseigenschaften des äußerst kompakt realisierbaren Resonators R2 stets optimal sind. Folglich bleibt das Abstimmverhalten der Laser-Anordnung 10 beim Verschwenken des Gitters 40 um die Achse 43 voll erhalten. Die Leistungsausbeute ist sehr hoch.

Die Erfindung ist nicht auf die vorbeschriebene Ausführungsform beschränkt, sondern in vielfältiger Weise abwandelbar. So sieht eine Ausführungsform vor im Beispiel von Fig. 1 die bevorzugt rotationssymmetrische Sammellinse 32 zwischen der Laser-diode 11 und der Zylinderlinse 34 anzuordnen. Es kann jedoch auch günstig sein, wenn man die Zylinderlinse 34 zwischen der Laserdiode 11 und der Sammellinse 32 anordnet. Um die Abbildung des Laserlichts 13 auf das Gitter 40 weiter zu verbessern, insbesondere um Abbildungsfehler zu vermeiden, ist es zweckmäßig, die Linse 32 als asphärische Linse auszubilden.

Die Laserdiode 11 hat bevorzugt eine aktive Zone mit einer rechteckigen Form. Um das Anschwingen von räumlichen Moden zu verhindern, kann man die aktive Zone trapezförmig ausbilden. Auch hierdurch erzielt man verbesserte Leistungswerte.

Eine noch andere Ausführungsform der Laserdioden-Anordnung 10 sieht vor, daß die Laserdiode 11 ein Quantenkaskadenlaser ist. Mit diesem lassen sich Wellenlängenbereiche von 4 µm bis 12 µm abdecken, was mit herkömmlichen Laserdioden nicht möglich ist. Die erfindungsgemäße Modifikation der Laserdiode 11 sorgt jedoch für eine stets modensprungfreie Durchstimmbarkeit. Alternativ kann man als Laserdiode 11 auch einen Quantenpunktlaser oder ein Dilute-Nitrid-Arsenid-Laser verwenden. Auch hierdurch können sich weitere anwendungsspezifische Vorteile ergeben.

Man erkennt, daß eine Laserdioden-Anordnung 10 zur Erzeugung von einmodiger, durchstimmbarer Laserstrahlung 15 eine Laserdiode 11 hat, die eine Rückfacette 16 und eine Frontfacette 17 aufweist und einen ersten Resonator R1 bildet. Ferner ist ein daran angekoppelter externer Resonator R2 vorgesehen, der wenigstens eine optische Transmissionskomponente 30 und wenigstens ein wellenlängenselektives optisches Reflexionselement 40, 50 aufweist und von der Laserdiode 11 emittiertes Laserlicht 13 in den ersten Resonator R1 zurückkoppelt. Um gegenüber herkömmlichen Anordnungen eine deutlich höhere Leistungsausbeute zu erzielen und um ferner die Wellenlänge frei von Modensprüngen frei von Modensprüngen durchstimmbar durchstimmen zu können, ist vorgesehen, daß die Laserstrahlung 15 über die Rückfacette 16 der Laserdiode 11 auskoppelbar ist, wobei das Verhältnis der Reflektivität der Rückfacette 16 zur Reflektivität des optischen Reflexionselements 40 sehr viel kleiner als 1, insbesondere kleiner als 0,1 ist. Im Bereich der Rückfacette 16 ist bevorzugt eine optische Transmissionskomponente 70 angeordnet, z.B. eine Kollimationslinse 72. Ferner ist an oder in dem ersten Resonator R1 eine Einrichtung 60 zur Variation der Ankopplungsgüte des ersten Resonators R1 an den externen Resonator R2 vorgesehen. Die Einrichtung 60 zur Variation der Ankopplungsgüte kann aber auch an oder in der Laserdiode 11 ausgebildet sein.

Sämtliche aus den Ansprüchen, der Beschreibung und der Zeichnung hervorgehenden Merkmale und Vorteile, einschließlich konstruktiver Einzelheiten, räumlicher Anordnungen und Verfahrensschritten, können sowohl für sich als auch in den verschiedensten Kombinationen erfindungswesentlich sein.

### Bezugszeichenliste

- A: Längsachse (Laserdiode)
- D: Länge (Laserdiode)
- H: Hauptsegment
- I: Länge (Anschlußsegment)
- L: Länge (Anschlußsegment)
- R1: Resonator
- R2: externer Resonator
- S: Steuersegment
- Z: Linsenachse

- 10: Laserdioden-Anordnung
- 11: Laserdiode
- 12: Träger
- 13: Laserstrahlung
- 14: Laserstrahlung
- 15: Laserlicht / Nutzstrahl
- 16: Rückfacette
- 17: Frontfacette

- 30: optische Transmissionskomponente
- 32: Kollimator / asphärische Linse
- 34: Zylinderlinse

- 40: optisches Reflexionselement / Gitter
- 42: Gitterlinien
- 43: Drehachse
- 44: Träger
- 46: Justiermittel
- 47: Teilgitter
- 48: Teilgitter

- 50: Spiegel
- 52: Tragarm
- 54: Drehachse

- 60: Einrichtung zur Variation der Ankopplungsgüte
- 61: elektrische Anschlußkontakte
- 62: Anschlußsegment
- 63: Anschlußsegment
- 64: Anschlußleitung
- 65: Anschlußleitung
- 66: Steuerung/Regler

- 70: optische Transmissionskomponente
- 72: Kollimator / asphärische Linse

## Patentansprüche

1. Laserdioden-Anordnung (10) zur Erzeugung von einmodiger, durchstimmbarer Laserstrahlung (15), mit einer Laserdiode (11), die eine Rückfacette (16) und eine Frontfacette (17) aufweist und einen ersten Resonator (R1) bildet, und mit einem daran angekoppelten externen Resonator (R2), der wenigstens eine optische Transmissionskomponente (30) und wenigstens ein wellenlängenselektives optisches Reflexionselement (40, 50) aufweist und von der Laserdiode (11) emittiertes Laserlicht (13) über die Frontfacette (17) in den ersten Resonator (R1) zurückkoppelt, wobei das optische Reflexionselement ein Beugungsgitter (40) umfasst und wobei die Laserstrahlung (15) über die Rückfacette (16) der Laserdiode (11) auskoppelbar ist, **dadurch gekennzeichnet,**
■ **daß** das Verhältnis der Reflektivität der Rückfacette (16) zur Reflektivität des optischen Reflexionselements (40) sehr viel kleiner als 1, vorzugsweise kleiner als 0,1 ist, wobei in beiden Fällen die Reflektivität der Rückfacette (16) kleiner oder gleich 0,01 und die Reflektivität des optischen Reflexionselements (40) größer oder gleich 0,95 ist, und
■ **daß** der Transmissionskomponente (30) eine zerstreuende Zylinderlinse (34) zugeordnet ist, deren parallel zu ihrer Zylindermantelfläche verlaufende Achse Z im wesentlichen parallel zu dem optischen Reflexionselement (40, 50) angeordnet ist, wobei die Achse Z der Zylinderlinse (34) parallel zu den Gitterlinien (42) des Beugungsgitters (40) verläuft.

2. Anordnung nach Anspruch 1, **dadurch gekennzeichnet, daß** die Laserdiode (11) in Axialrichtung (A) eine Länge (D) aufweist, die größer oder gleich 500 µm ist.

3. Anordnung nach Anspruch 1 oder 2, **dadurch gekennzeichnet, daß** im Bereich der Rückfacette (16) eine optische Transmissionskomponente (70) angeordnet ist, z.B. eine Kollimationslinse (72).

4. Anordnung nach einem der Ansprüche 1 bis 3, **dadurch gekennzeichnet, daß** eine Einrichtung (60) zur Variation der Ankopplungsgüte des ersten Resonators (R1) an den externen Resonator (R2) vorgesehen ist.

5. Anordnung nach Anspruch 4, **dadurch gekennzeichnet, daß** die Einrichtung (60) zur Variation der Ankopplungsgüte an oder in dem ersten Resonator (R1) ausgebildet ist.

6. Anordnung nach Anspruch 4 oder 5, **dadurch gekennzeichnet, daß** die Einrichtung (60) zur Variation der Ankopplungsgüte an oder in der Laserdiode (11) ausgebildet ist.

7. Anordnung nach Anspruch 6, **dadurch gekennzeichnet, daß** die Einrichtung (60) zur Variation der Ankopplungsgüte einen auf der Laserdiode (11) aufgebrachten elektrischen Anschlußkontakt (61) umfaßt, der in voneinander unabhängig ansteuerbare Anschlußsegmente (62, 63) unterteilt ist.

8. Anordnung nach Anspruch 7, **dadurch gekennzeichnet, daß** der Anschlußkontakt (61) senkrecht zur Längsachse (A) der Laserdiode (11) unterteilt ist, wobei das der Rückfacette (16) zugewandte erste Anschlußsegment (62) eine Länge (L) aufweist, die größer ist als die Länge (I) des weiteren Anschlußsegments (63).

9. Anordnung nach Anspruch 7 oder 8, **dadurch gekennzeichnet, daß** jedes Anschlußsegment (62, 63) über eine Regelschaltung (66) mit einem Steuerstrom beaufschlagbar ist.

10. Anordnung nach einem der Ansprüche 1 bis 9, **dadurch gekennzeichnet, daß** die Rückfacette (16) der Laserdiode (11) verspiegelt ist.

11. Anordnung nach einem der Ansprüche 1 bis 10, **dadurch gekennzeichnet, daß** die dem externen Resonator (R2) zugewandte Frontfacette (17) der Laserdiode (11) mit einer Antireflexionsbeschichtung versehen ist.

12. Anordnung nach Anspruch 11, **dadurch gekennzeichnet, daß** die Reflektivität der antireflexionsbeschichteten Frontfacette (17) kleiner als 0,001 beträgt.

13. Anordnung nach einem der Ansprüche 1 bis 12, **dadurch gekennzeichnet, daß** die optische Transmissionskomponente (30) einen Kollimator (32) aufweist.

14. Anordnung nach einem der Ansprüche 1 bis 13, **dadurch gekennzeichnet, daß** das wellenlängenselektive Reflexionselement (40) ein optisches Beugungsgitter ist.

15. Anordnung nach einem der Ansprüche 1 bis 14, **dadurch gekennzeichnet, daß** das wellenlängenselektive Reflexionselement (50) ein Spiegel ist.

16. Anordnung nach einem der Ansprüche 1 bis 15, **dadurch gekennzeichnet, daß** die Laserdiode (11) und der externe Resonator (R2) eine Littman- oder eine Littrow-Anordnung bilden.

17. Anordnung nach einem der Ansprüche 1 bis 16, **dadurch gekennzeichnet, daß** die Laserdiode (11) ein Quantenkaskadenlaser, ein Quantenpunktlaser oder ein Dilute-Nitrid-Arsenid-Laser ist.

18. Anordnung nach einem der Ansprüche 1 bis 17, **dadurch gekennzeichnet, daß** die Zylinderlinse (34) zwischen der Laserdiode (11) und dem Kollimator (32) angeordnet ist.

19. Anordnung nach Anspruch 18, **dadurch gekennzeichnet, daß** der Kollimator (32) zwischen der Laserdiode (11) und der Zylinderlinse (34) angeordnet ist.

20. Anordnung nach wenigstens einem der Ansprüche 1 bis 19, **dadurch gekennzeichnet, daß** das optische Reflexionselement (40) von zwei Teilgittern (47, 48) gebildet wird, die in einem Winkel von 90° zueinander angeordnet sind.

## Claims

1. Laserdiode assembly (10) to create single-mode tuneable laser illumination (15) with a laserdiode (11), showing a back facet (16) and a front facet (17) to form a first resonator (R1), and with an external resonator coupled thereto (R2) that has at least one optical transmission component (30) and at least one wavelength-selective optical reflection element (40, 50) and couples back by the laserdiode (11) emitted laser light (13) over the front facet (17) in the first resonator (R1), with the optical reflection element comprising an intracavity laser diffraction grating (40) and with the laser illumination (15) being coupled out via the back facet (16) of the laserdiode (11), **characterized by** the ratio of the reflectivity of the back facet (16) to the reflectivity of the optical reflection element (4) being considerably smaller than 1, preferably smaller than 0,1, with in both cases the reflectivity of the back facet (16) being smaller than or equal to 0,01 and the reflectivity of the optical reflection element (40) being greater than or equal to 0,95, and the transmission component (30) has an associated cylindrical lens whose axis Z running parallel to its cylindrical surface area is basically in parallel arrangement to the optical reflection element (40, 50) with the axis Z of the cylindrical lens (34) runs parallel to the grating rulings (42) of the intracavity laser diffraction grating (40).

2. Assembly according to claim 1, **characterized by** the laserdiode (11) showing in axial direction (A) a length (D) greater than or equal to 500µm.

3. Assembly according to claims 1 or 2, **characterized by** an optical transmission component (70), e. g. a collimation lens (72), being assembled in the area of the back facet (16).

4. Assembly according to one of the claims 1 to 3, **characterized by** a device (60) to vary the coupling-on quality of the first resonator (R1) being provided for at the external resonator (R2).

5. Assembly according to claim 4, **characterized by** the device (60) to vary the coupling-on quality being formed at or in the first resonator (R1).

6. Assembly according to claims 4 or 5, **characterized by** the device (60) to vary the coupling-on quality being formed at or in the laserdiode (11).

7. Assembly according to claim 6, **characterized by** the device (60) to vary the coupling-on quality including an electric connecting contact (61) fixed on the laserdiode (11) and being divided into individually approachable connecting segments (62, 63) independent from each other.

8. Assembly according to claim 7, **characterized by** the connecting contact (61) being divided vertically to the longitudinal axis (A) of the laserdiode (11), with the first connecting segment (62) oriented toward the back facet (16) having a length (L) superior to the length (I) of the other connecting segment.

9. Assembly according to claims 7 or 8, **characterized by** each connecting segment (62, 63) receiving a control current over a regulating circuit (66).

10. Assembly according to one of the claims 1 to 9, **characterized by** the back facet (16) of the laserdiode (11) being mirrored.

11. Assembly according to one of the claims 1 to 10, **characterized by** the front facet (17) of the laserdiode (11) oriented toward the external resonator (R2) having an antireflection coating.

12. Assembly according to claim 11, **characterized by** the reflectivity of the antireflection coated front facet (17) being below 0,001.

13. Assembly according to one of the claims 1 to 12, **characterized by** the optical transmission component (30) having a collimator (32).

14. Assembly according to one of the claims 1 to 13, **characterized by** the wavelength-selective reflection element (40) being an optical intracavity laser diffraction grating.

15. Assembly according to one of the claims 1 to 14, **characterized by** the wavelength-selective reflection element (50) being a mirror.

16. Assembly according to one of the claims 1 to 15, **characterized by** the laserdiode (11) and the external resonator (R2) forming a Littman- or Littrow-arrangement.

17. Assembly according to one of the claims 1 to 16, **characterized by** the laserdiode (11) being a quantum-cascade laser, a quantum-point laser, or a dilute-nitride-arsenide laser.

18. Assembly according to one of the claims 1 to 16, **characterized by** the cylindrical lens (34) being positioned between the laserdiode (11) and the collimator (32).

19. Assembly according to claim 18, **characterized by** the collimator (32) being positioned between the laserdiode (11) and the cylindrical lens (34).

20. Assembly according to at least one of the claims 1 to 19, **characterized by** the optical reflection element (40) is formed of two partial gratings (47, 48) placed to each other in an angle of 90°.

## Revendications

1. Arrangement de diodes de laser (10) pour un rayonnement de laser unimodal ajustable (15) avec une diode laser (11), qui montre une facette arrière (16) et une facette avant (17) et forme un premier résonateur (R1) et avec un résonateur externe (R2) attaché, qui montre au moins un composant de transmission optique (30) et au moins un l'élément de réflexion optique sélectif en longueur d'onde (40, 50) et qui recouple la lumière laser (13) émise par la diode laser (11) par la facette avant (17) au premier résonateur (R1), et le rayonnement laser (15) peut être déclenché à travers de la facette arrière (16) de la diode laser (16), **caractérisé en ce que**,
- la relation de la réflectivité de la facette arrière (16) à la réflectivité de l'élément de réflexion optique (40) est inférieure à 1, de préférence inférieure à 0,1, dans les deux cas la réflectivité de la facette arrière (16) étant inférieure ou égale à 0,01 et la réflectivité de l'élément de réflexion optique (40) étant supérieure ou égale à 0,95, et
- une lentille cylindrique dispersive (34) est attribuée au composant de transmission, dont l'axe parallèle à son enveloppe de cylindre (Z) se trouve principalement parallèle à l'élément de réflexion optique (40, 50), l'axe (Z) de la lentille cylindrique (34) s'étendant en parallèle aux lignes de la grille (42) de la grille du réseau de diffraction (40).

2. Arrangement selon la revendication 1, **caractérisé en ce que** la diode laser (11) montre une longueur (D) dans la direction axiale, qui est supérieure ou égale à 500 µm.

3. Arrangement selon la revendication 1 ou 2, **caractérisé en ce que** dans la section de la facette arrière (16) est placé un composant de transmission optique (70), p. ex. une lentille de collimation (72).

4. Arrangement selon une des revendications de 1 à 3, **caractérisé en ce que** le dispositif (60) pour la variation de la qualité de couplage du premier résonateur (R1) est prévu au résonateur externe.

5. Arrangement selon la revendication 4, **caractérisé en ce que** le dispositif (60) pour la variation de la qualité de couplage du premier résonateur (R1) est formé au / ou dans le premier résonateur.

6. Arrangement selon la revendication 4 ou 5, **caractérisé en ce que** le dispositif (60) pour la variation de la qualité de couplage du premier résonateur (R1) est formé à / ou dans la diode laser (11).

7. Arrangement selon la revendication 6, **caractérisé en ce que** le dispositif (60) pour la variation de la qualité de couplage du premier résonateur (R1) englobe un contact de raccordement électrique appliqué sur la diode laser (61), qui est divisé en segments de raccordement, indépendants les uns des autres.

8. Arrangement selon la revendication 7, **caractérisé en ce que** le contact de raccordement (61) est divisé perpendiculairement à l'axe longitudinal (A) de la diode laser (11), le premier segment de raccordement (62) orienté vers la facette arrière (16) ayant une longueur (L) supérieure à la longueur (I) de l'autre segment de raccordement.

9. Arrangement selon la revendication 7 ou 8, **caractérisé en ce que** chaque segment de raccordement (62, 63) peut recevoir un courant de commande à travers un circuit de réglage.

10. Arrangement selon une des revendications 1 à 9, **caractérisé en ce que** la facette arrière (16) de la diode laser (11) est miroitée.

11. Arrangement selon la revendication 1 à 10, **caractérisé en ce que** la facette avant (17) orientée vers le résonateur externe (R2) de la diode laser (11) est munie d'une couche antireflets.

12. Arrangement selon la revendication 1, **caractérisé en ce que** la réflectivité de la facette avant munie d'une couche antireflets (17) est inférieure à 0.001.

13. Arrangement selon une des revendications 1 à 12, **caractérisé en ce que** le composant de transmission optique (30) comprend un collimateur (32).

14. Arrangement selon une des revendications 1 à 13, **caractérisé en ce que** l'élément de réflexion sélectif en longueur d'onde (40) est un réseau de diffraction optique.

15. Arrangement selon une des revendications 1 à 14, **caractérisé en ce que** l'élément de réflexion sélectif en longueur d'onde (50) est un miroir.

16. Arrangement selon une des revendications 1 à 15, **caractérisé en ce que** la diode laser (11) et le résonateur externe (11) (R2) forment un arrangement du type Littmann ou Littrow.

17. Arrangement selon une des revendications 1 à 16, **caractérisé en ce que** la diode laser (11) est un laser à cascade quantique, un laser à point quantique ou un laser à dilution nitrure arséniure.

18. Arrangement selon une des revendications 1 à 17, **caractérisé en ce que** la lentille cylindrique (34) est placée entre la diode laser (11) et le collimateur (32).

19. Arrangement selon la revendication 18, **caractérisé en ce que** le collimateur (32) est placé entre la diode laser (11) et la lentille cylindrique (34).

20. Arrangement selon une des revendications 1 à 19, **caractérisé en ce que** l'élément de réflexion optique (40) est formé de deux grilles partielles (47, 48) placées sous forme d'un angle à 90°.
